**Europäisches Patentamt**

**European Patent Office**

**Office européen des brevets**

(19)

(11)  **EP 1 434 142 A1**

(12) ## EUROPEAN PATENT APPLICATION

(43) Date of publication:
**30.06.2004 Bulletin 2004/27**

(51) Int Cl.[7]: **G06F 17/14**

(21) Application number: **02447274.8**

(22) Date of filing: **24.12.2002**

(84) Designated Contracting States:
**AT BE BG CH CY CZ DE DK EE ES FI FR GB GR IE IT LI LU MC NL PT SE SI SK TR**
Designated Extension States:
**AL LT LV MK RO**

(71) Applicant: **STMicroelectronics Belgium N.V.**
**1930 Zaventem (BE)**

(72) Inventor: **Pisoni, Fabio**
**20020 Busto Garolfo (IT)**

(74) Representative: **Bird, William Edward et al**
**Bird Goen & Co.,**
**Klein Dalenstraat 42A**
**3020 Winksele (BE)**

(54) **Method and system to calculate Fractional Fourier Transform**

(57)  An M-point Fractional Fourier is described using several 2M-points traditional Fourier transforms. The signal path is fed through a series of blocks including a first multiplier, a zero pad, an FFT 2m, a second multiplier, an IFFT 2M, a 1$^{st}$ half element, and a third multiplier. The first and third multipliers have as their other inputs a value exp(-j n$^2$) for n=0:M-1, derived from the clock offset signal represented by.

FIG 5

**Description**

**FIELD OF THE INVENTION**

This invention relates to convolver arrangements and methods for calculating fast fractional Fourier transforms and their inverse which may find application in telecommunications devices such as interpolators, transceivers having such interpolators, modems including such transceivers and to corresponding software and methods.

**BACKGROUND TO THE INVENTION**

Asymmetric high speed Digital Subscriber Line (ADSL) and Very high speed Digital Subscriber Line (VDSL) are examples of modem communication systems which permit transmission of data over band-limited communication lines at very high rates, e.g., up to 52 Mbits/s - see for example "ADSL, VDSL and Multicarrier Modulation", J. A. C. Bingham, Wiley, 2000. They are examples of multi-carrier systems. Multi-carrier modulation is a well known means of transmitting digital data by splitting that data into fixed-length data "blocks" or "symbols" each having the same number of sub-blocks or bits. Analogue transmission of these blocks is carried out using a set of carrier signals. There is a carrier for each of the sub-blocks in one block. The carriers have frequencies which are equally spaced across the transmission band of the transceiver. One such arrangement is called DMT (Discrete multi-tone). DMT modems transmit data by dividing it into several interleaved bit streams, and using these bit streams to modulate several carriers.

Another application of multicarrier modulation is in OFDM systems, as described for instance in "OFDM for Wireless Multimedia Communications", R. van Nee and R. Prasad, Artech House, 2000. Applications are for example, wireless LAN's. This modulation technique also finds application in Satellite communications, see for example, "Satellite Communications Systems", G. Maral, M. Bousquet, Wiley, 1998.

In a receiver for use in an ADSL system for instance, following Time Domain Equalization (TEQ), removal of the cyclic prefix (CP), followed by a Fast Fourier Transform (FFT), complementary to the IFFT of the transmitter, is performed. The signal may then be passed to a frequency domain equalizer (FDEQ), to recover the signals as transmitted from the received signals, e.g. QAM symbols, from which the bit streams are recovered.

Calculating Fast Fourier transforms and their inverses can nowadays be done by standard components and software packages. However, there is also a need to calculate fractional Fourier transforms in an efficient manner.

**SUMMARY OF THE INVENTION**

It is an aim of the present invention to provide improved apparatus and methods. According to a first aspect of the present invention, there is provided a method an apparatus to carry out a Fast Fractional Fourier Transform, It enables the amount of processing to be limited.

The present invention also provides a transmitter or a receiver having a Fast Fractional Fourier Tranform arrangement.

The present invention also provides a modem having the transmitter and the receiver described above.

The modem described above may be fabricated as an integrated circuit.

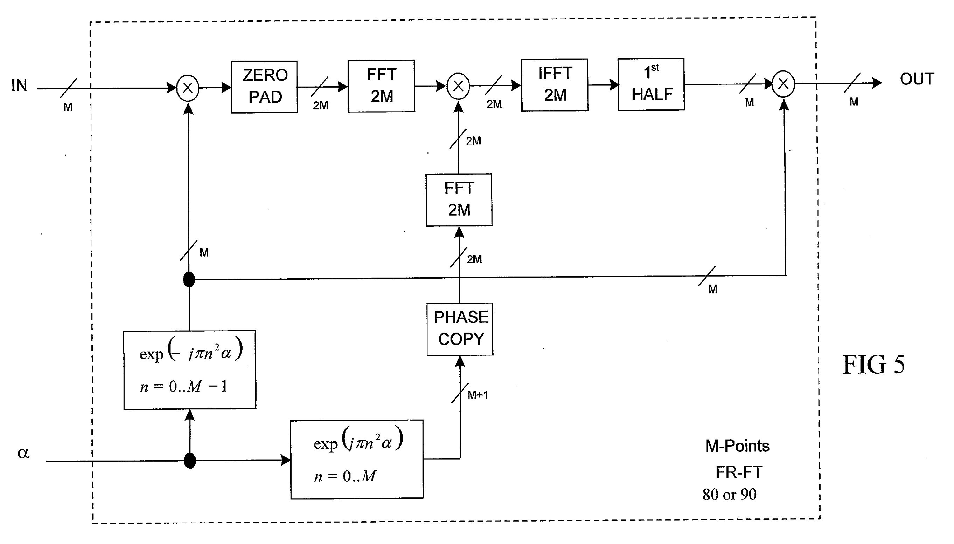

In one aspect of the present invention a fast-convolver using 2N points to emulate linear convolution through FFTs, as shown in figure 5 is provided. In particular, an N-points Fractional Fourier Transform arrangement or circuit is disclosed comprising at least one 2N-points fast Fourier transform block. In addition the circuit may comprise a 2N-points inverse Fast Fourier transform block and a further 2N-points fast Fourier transform block. Another aspect of the present invention is a fast-convolving method using 2N point processing to emulate linear convolution through FFTs, as shown in figure 5. In particular, a method of N-points Fractional Fourier Transforming is disclosed comprising at least one 2N-points fast Fourier transform. In addition the method may comprise a 2N-points inverse Fast Fourier transform and a further 2N-points fast Fourier transform.

Another aspect of the invention provides software for implementing the fast fractional Fourier transform above. This is intended to encompass software for carrying out (which encompasses controlling) corresponding method steps. This acknowledges that such software can be a valuable, separately tradable commodity. An fractional fast Fourier transform arrangement in the form of software is intended to encompass software which runs on or controls "dumb" or standard hardware, to carry out the desired functions, (and therefore the software essentially defines the functions of the arrangement, even before it is combined with its standard hardware). For similar reasons, it is also intended to encompass software which "describes" or defines the configuration of hardware, such as HDL (hardware description language) software, as is used for designing silicon chips, or for configuring universal programmable chips, to carry out desired functions.

As the advantages set out above can feed through to enable a better network, which is more reliable or more flexible, or greater capacity, or more cost effective for example, consequently a communication service over the network can show a corresponding improvement, and directly affect the value of such services. Such increased value over the life of the system, could prove far greater than the sales value of the equipment.

Any of the features can be combined with any of the aspects of the invention as would be apparent to those skilled in the art. Other advantages will be apparent to those skilled in the art.

## BRIEF DESCRIPTION OF THE DRAWINGS

To show by way of example how the invention can be implemented, embodiments will now be described with reference to the figures in which:

Fig 1 shows an embodiment in the form of a modem having a TDFI (transform domain fractional interpolator) clock offset compensation arrangement,
Fig 2 shows an embodiment of a clock offset compensation arrangement based on chirp carrier interpolation,
Figs 3 to 6 show aspects of the clock compensation arrangements based on fractional Fourier (Chirp type) transform arrangements according to embodiments of the present invention.
Figs 7 and 8 show aspects of the clock compensation arrangements for a receive path,
Fig 9 shows an approximation for a fractional transform, and
Fig 10 shows a rate adapter according to another embodiment.

## DETAILED DESCRIPTION OF PREFERRED EMBODIMENTS

In the drawings, and in the following descriptions, like elements have been assigned like numerals for the sake of consistency. The present invention will be described with reference to certain embodiments and drawings but the present invention is not limited thereto. The skilled person will appreciate that the present invention has wide application as indicated by the attached claims, for example, in xDSL, VDSL, ADSL modems, satellite transmitters and receivers, Wireless local area network receivers or transmitters, e.g using multicarrier modulation such as OFDM.

The fast fractional Fourier transform will mainly be described with reference to its application in an interpolator but this is by way of example only and the arrangement and method embodied in the arrangement have wider application and are not limited to this application.

For the present purpose of this document, the clock-offset will be assumed to be perfectly estimated on a symbol-by-symbol time base, though in practice it is appreciated it will be a source of small additional error. Further, a rotor may be added into any of the embodiments of the present invention in addition to an interpolator to provide additional compensation according to the clock offset signal.

Before describing implementation of embodiments of the compensation arrangement, a typical application will be described.

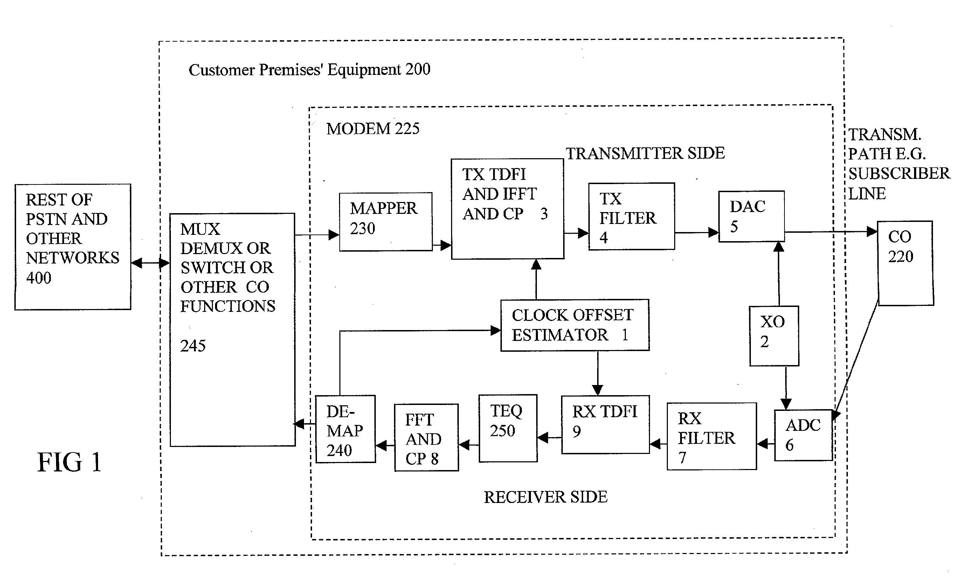

### Fig 1, modem having clock offset compensation

In Figure 1, there is illustrated a modem 225 having a discrete multi-tone (DMT) transceiver, which includes a receiver side and a transmitter side employing a compensation arrangement TDFI 3, 9 according to respective embodiments of the present invention. The modem is located in a CP (Customer Premises) 200 coupled to a subscriber line for transmitting to or receiving from a Central Office 220. The embodiments are equally applicable at the Central Office side or in other types of multicarrier communications links such as cable connections, wireless links and so on. The modem is shown incorporated in customer premises' equipment having other functions 245 such as mux or demux or switching, to couple many subscriber lines via modems to the rest of the PSTN or other networks 400.

The transmitter side has a mapper 230 for receiving data to be modulated and transmitted, and a signal output for outputting transmit signals to a digital-to-analog converter (DAC) 5 for subsequent transmission. The receiver side has a receive signal input for receiving signals transmitted from remote transceivers via an analog-to-digital converter (ADC) 6, and a receive data output for outputting dispersion suppressed received data to a demapper 240. A transmission path exists from the transmitter portion output to the CO 220, and another exists in the reverse direction to the receiver portion input along the subscriber line. The path includes at least a hybrid transformer (not shown) of the transceiver and may include other elements of the transceiver located outside the transmitter portion and the receiver portion of the transceiver.

In the transmitter side, the mapper feeds a TX (transmitter) TDFI (transform domain fractional interpolator) 3 which also has an inverse fast Fourier transform unit (IFFT) and cyclic prefix part CP for adding a guard band in the form of a cyclic prefix between each block or symbol. This part receives input data in the form of frequency-domain DMT data blocks comprised of N complex-valued data elements from the mapper. The TDFI carries out clock offset compensation as described below, according to a clock offset output by estimator 1, derived from received signals.

The IFFT part modulates each of the N data elements with N carrier signals at evenly spaced frequency intervals thereby converting the N frequency-domain data elements into a block (or "symbol") of N real-valued time-domain samples.

The cyclic prefix part (CP) copies the last L samples of the N time-domain sample block to form a cyclic prefix therewith, and prepends the cyclic prefix to the beginning of the block. This is done in order to reduce inter-block interference at the remote transceiver to which the block of (N+L) samples is subsequently transmitted. The output of the cyclic prefix part is DMT transmit signals comprising a plurality of time-domain multi-carrier transmit blocks/symbols.

The DMT transmit signals are subsequently passed through a transmitter low-pass filter unit 4 and thence through a digital-to-analogue converter DAC 5 prior to duplex transmission to the remote transceiver.

The receiver portion input is coupled to an analogue-to-digital converter (ADC) 6 arranged to digitise received DMT time-domain signals received from a remote transceiver, and to pass those signals, so digitised, through a receiver filter 7.

Before time domain equalization is applied by TEQ 250, clock offset is compensated by the RX (receive side) TDFI (Transform domain fractional interpolator) to the signals output of the receive filter 7. As in the transmit side, this is carried out according to the clock offset signal from the estimator 1. After time domain equalization, an FFT and CP part removes the cyclic prefix guard band and converts the signal into frequency domain signals.

These are fed to the demapper 240 to produce demodulated data samples following conventional principles. The output of the receiver side of the modem is passed on to other parts of the central office equipment for onward routing and transmission. Other parts of the modem such as echo cancellation and so on are not shown for the sake of clarity. The data transmitted can be anything including digitized voice call information, packet data relating to internet access or any other type of communication service.

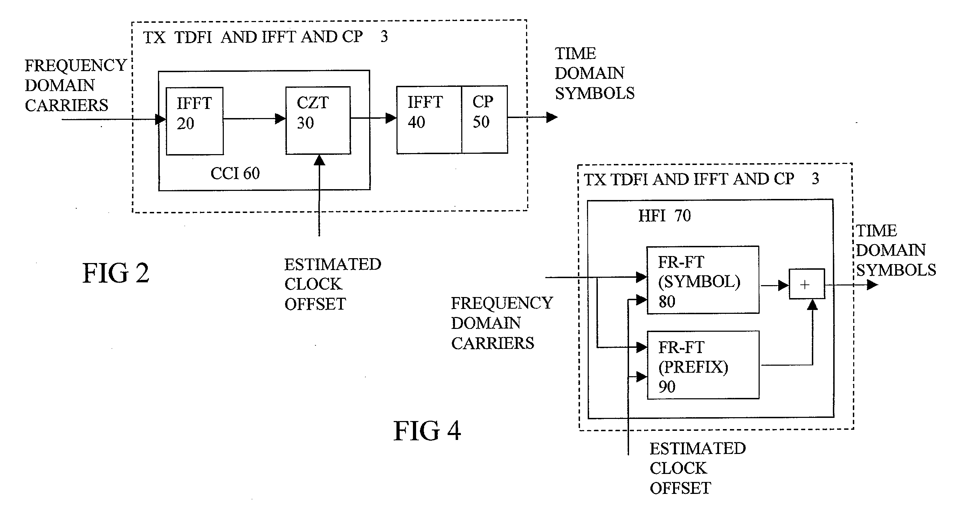

**Fig 2, Chirp Carrier Interpolator for TX TDFI**

Figure 2 shows an embodiment of a compensation arrangement according to an embodiment of the invention. It represents one of a number of ways of implementing the TX TDFI and IFFT and CP part 3 of figure 1, or can be used in other applications. This part includes a Chirp Carrier Interpolator CCI 60, which feeds an IFFT part 40 followed by a CP part 50. The CCI comprises another IFFT part 20 in series with a CZT (chirp Z transform) part 30. The CCI part takes frequency domain inputs and carries out a clock offset compensation digitally in a transform domain based on linear Fourier and Z-chirp transforms. The transforms are chosen to minimize computational load. An explanation of their derivation now follows, starting with an analysis of the effects of clock offset. The term chirp refers to changes in the frequency of a signal with time.

Clock-Offset introduces a tone-dependant frequency shift and a sample-dependant time delay. A non-oversampled system (NFt=F0) is assumed, and the following definitions are used:

T0 = the nominal sampling period at TX @2.208 MHz
Ts = the real sampling period at RX ADC:
ppm = the precision mismatch (worst case for ADSL ppm=250)

$$k,n=0..N\text{-}1$$

$$10^6 \cdot T_0 = \left(10^6 - ppm\right) \cdot T_s$$

$$F_0 = \frac{1}{T_0} \qquad F_S = \frac{1}{T_S}$$

$$F_s = F_0 \frac{10^6 - ppm}{10^6} = F_0\left(1 - \frac{ppm}{10^6}\right)$$

$$T_s = T_0\left(\frac{10^6}{10^6 - ppm}\right)$$

$$\Delta F_T = \frac{F_S - F_0}{N} = -\frac{1}{N} F_0 \frac{ppm}{10^6}$$

$$\Delta T = T_s - T_0 = T_0 \left( \frac{ppm}{10^6 - ppm} \right)$$

The sub-carrier frequency offset for the sub-carrier k, and the time-delay accumulated at sample n and the correspondent new grids k'and n' are:

$$\Delta f_k = k \cdot \Delta F_T = -\frac{k}{N} F_0 \frac{ppm}{10^6} \qquad \Delta t_n = n \cdot \Delta T = n \cdot T_0 \left( \frac{ppm}{10^6 - ppm} \right)$$

$$k' = k + \frac{\Delta f_k}{F_T} = k\alpha \qquad n' = n + \frac{\Delta t_n}{T_0} = \frac{n}{\alpha}$$

$$\alpha = 1 - \frac{ppm}{10^6}$$

The phase offset introduced by varying the carrier k or sample n (and keeping the other constant) are:

$$\Phi(n, k) = 2\pi \cdot f_k t_n \qquad k,n = 0..N-1$$

$$\Delta\Phi_{\bar{n}}(k) = 2\pi \cdot \Delta f_k t_n = 2\pi \left( -\frac{k}{N} F_0 \frac{ppm}{10^6} \right) \cdot \bar{n} T_0 = -\frac{2\pi}{N} k\bar{n} \frac{ppm}{10^6} = -\frac{2\pi}{N} k\bar{n}(1-\alpha)$$

$$\Delta\Phi_{\bar{k}}(n) = 2\pi \cdot f\Delta_k t_n = 2\pi \left( \bar{k} \frac{F_0}{N} \right) \cdot n T_0 \frac{ppm}{10^6 - ppm} = \frac{2\pi}{N} \bar{k}n \frac{ppm}{10^6 - ppm} = \frac{2\pi}{N} \bar{k}n \left( \frac{1-\alpha}{\alpha} \right)$$

Chirp Carrier Interpolation: The frequency interpolation formula given its samples is (DC at index k/2+1, N is even):

$$X(\omega) = \frac{1 - e^{-j\omega N}}{N} \sum_{k=-N/2}^{N/2-1} \frac{X(k)}{1 - e^{-j(\omega - 2\pi k/N)}}$$

Evaluating on the fractional grid h :

$$\omega(h\alpha) = 2\pi h\alpha/N \qquad h = -N/2..+N/2-1$$

$$X(h\alpha) = \frac{1 - e^{-j2\pi h\alpha}}{N} \sum_{k=-N/2}^{N/2-1} \frac{X(k)}{1 - e^{-j2\pi/N(h\alpha-k)}}$$

The following Chirp Z-Transform can be defined over the time-sequence x(n):

$$r_0 = R_0 = 1 \qquad \vartheta_0 = 0 \qquad \Phi_0 = 2\pi\alpha/N$$

$$X_c(m) = r_0 e^{j\vartheta_0} \sum_{n=0}^{N-1} x(n) e^{-j\Phi_0 k}$$

$$= \sum_{n=0}^{N-1} x(n) e^{-j2\pi k\alpha m/N}$$

Given an aliased form Xa of X (DC is at index 0 Xa=fftshift (X)):

$$X_c(m) = \sum_{n=0}^{N-1} x(n) e^{-j2\pi m\alpha n/N}$$

$$= \sum_{n=0}^{N-1} \left[ \sum_{k=0}^{N-1} X_a(k) e^{j2kn/N} \right] e^{-j2\pi m\alpha n/N}$$

$$= \sum_{k=0}^{N-1} X_a(k) \cdot \sum_{n=0}^{N-1} e^{j2\pi(k-m\alpha)n/N}$$

$$= \frac{1}{N} \sum_{k=0}^{N-1} X_a(k) \frac{1-e^{j2\pi(k-m\alpha)}}{1-e^{j2\pi(k-m\alpha)/N}}$$

$$= \frac{1-e^{-j2\pi m\alpha}}{N} \sum_{k=0}^{N-1} \frac{X_a(k)}{1-e^{-j2\pi(m\alpha-k)/N}}$$

$$= \frac{1-e^{-j2\pi m\alpha}}{N} \sum_{k=-N/2}^{N/2-1} \frac{X(k)}{1-e^{-j2\pi(m\alpha-k)/N}} = X(m\alpha)$$

Thus, the interpolated carriers on the fractional grid k (where is a non-integer number) can be efficiently computed from the carriers X on the normal grid k by an inverse-FFT over X followed by a Chirp Z-Transform. This result is particularly useful because fast implementations of the Chirp Z-Transform transform are presented by the present invention with complexity 0 (N*log (N)) which enables computational load to be eased.

Based on this result, the CCI takes as input the carriers to be transmitted and interpolate them on a fractional grid based on the estimated clock-offset. The interpolated carriers are then fed to the normal IFFT without needing an additional TDI part. The cyclic prefix has to be chirped independently.

The CCI is specified by the following "Matlab" function:

```
% X = carrier input (non-aliased format)
% Xw = interpolated carrier (non-aliased format)
% ppm = clock mismatch
%
function Xw = cci_interp (X, ppm)
alpha = 1 - ppm/1e6;
        N = length(X);
w = exp (-sqrt (-1)*2*pi/N*alpha);
A = exp (-sqrt (-1)*2*pi/N*(N/2)*alpha);
        x = ifft(fftshift(X));
        Xw = czt ( x, N, w, A);
        Xw(1) = 1/N*sum(X); %
    return;
```

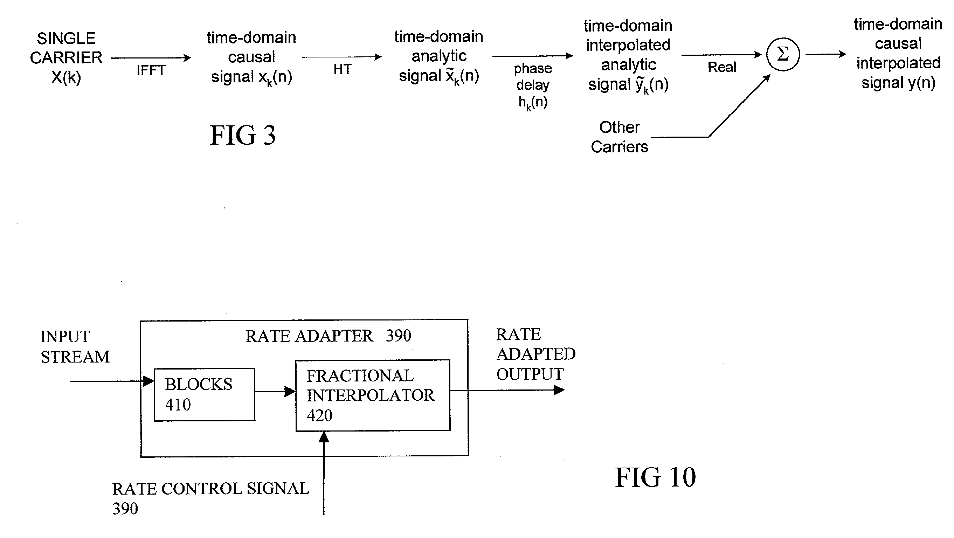

**Figs 3-6, Hilbert Fractional Interpolation in TX path**

An alternative way of implementing the TX TDFI and IFFT and CP part 3 of figure 1 will now be described with reference to figures 3-6. This alternative can be used in other applications. It is based on a different type of transform, using Hilbert Fractional Interpolation, and in the TX path it can operate on frequency domain carriers as an input and output time-domain signals.

Given a time domain causal signal xk(n) n=0..N-1 the instantaneous phase is defined as the phase of the correspondent analytic signal, where HT(x) indicate the Hilbert transform of x:

$$\Phi_k(n) = arg\ (x_k(n) + j \cdot HT(x_k(n)))\qquad n=0..N\text{-}1$$

When a single-tone k is passed throught the IFFT, and a clock-offset of ppm (part per million) is present, then the istantaneous phase of the time-domain analytic signal will be given the following offset:

$$\Delta\Phi_k\ (n) = \frac{2\pi}{N}kn\frac{1-\alpha}{\alpha}\qquad k,n=0..N\text{-}1$$

$$\alpha = 1 - \frac{ppm}{10^6}$$

For single-tone analytic signals in particular, the phase is localized in time. The phase delay effect can be easily computed as a vector product by hk(n). As the Hilbert and Fourier transforms are linear, each analytic single-tone component can be delayed separately and then summed together. The principle is shown in figure 3. This shows how a single carrier is subject to an IFFT to give a time-domain causal signal. This is subject to a Hilbert Transform to give a time domain analytic signal, which after a phase delay becomes a time domain interpolated analytic signal. The same signals derived from other carriers can be summed to give the output, a time domain causal interpolated signal. Following the signal names shown in figure 3, the expression for the interpolated (causal) signal xw(n) is obtained as follows:

$$\widetilde{x}_k(n) = \frac{2}{N}X(k)\cdot \exp\left(j\frac{2\pi}{N}kn\right)$$

$$h_k(n) = \exp(j\cdot\Delta\Phi_k(n)) = \exp\left(j\frac{2\pi}{N}kn\frac{1-\alpha}{\alpha}\right)$$

$$y(n) = \sum_{k=0}^{N/2-1}\widetilde{x}_k(n)\cdot h_k(n) = \frac{2}{N}\sum_{k=0}^{N/2-1}X(k)\cdot\exp\left(j\frac{2\pi}{N}nk\frac{1}{\alpha}\right)$$

The fractional-Fourier transform Gk of δ over a generic signal s(k) is defined as follows (different definitions for the FRFT exist, the one used here is indeed a chirp-Z-transform).

$$G_k\big(s(k),\delta\big) = \sum_{k=0}^{N-1}s(k)\cdot\exp\big(-j2\pi nk\delta\big)\ k = 0..N-1$$

Hence, by comparing this definition with the expression of y(n) it can be seen that the (causal) interpolated signal y(n) can be obtained by a fractional Fourier transform (real part of) over the single side spectrum $\widetilde{x}_s(k)$ k=0..N-1 obtained by X(k) as follows. (The DC component has to be halved as the number of carriers is even. Also the Nyquist carrier is assumed to be zero):

$$\widetilde{X}_s(k) = \begin{cases} X(k)/2 & k = 0 \\ X(k) & k = 1..N/2 - 1 \\ 0 & k = N/2..N - 1 \end{cases}$$

$$y(n) = \frac{2}{N} G_k\left(\widetilde{X}_s(k), \frac{-1}{\alpha N}\right) \qquad k = 0..N-1$$

As before, this is valuable because fast implementations of the fractional Fourier transform exists with complexity O(N*log2(N) so this can enable computational load to be eased. In accordance with an embodiment of the present invention an implementation of the Fast Fractional Fourier algorithm is specified in the following Matlab function (merely for convenience) for both even and odd length of the vector x:

```
%
% Fast fractional frourier transform
% return Gk(x,alpha) with k=0..N-1
% where:
% N=length(x)       (even case)
% N=length (x)-1      (odd case)
%
function G = fast_frf( x, alpha )
M = length (x) ;
if (mod (M, 2))
        N = M-1;        % x odd length
        P = N-1;
else
        N = M;        % x even length
        P = N;
end
y = [x.' .*exp(-sqrt (-1)*pi*(0:M-1).^2*alpha), zeros(1,P)] .' ;
z = [exp(sqrt (-1)*pi*(0:N-1).^2*alpha) , exp(sqrt(-1) *pi* (N: -1 : 1) . ^2*alpha) ] .' ;
w = ifft ( fft (y) . .* fft (z) ) ;
G = w(1:N) .* exp( -sqrt (-1)*pi* (0:N-1).^2*alpha).'; .
return;
```
The normal direct/inverse Fourier transform can be obtained as special cases:

$$\left.\begin{aligned} \mathrm{fft}(x) &= \mathrm{fast\_frf}(x, 1/N) \\ \mathrm{ifft}(x) &= \frac{1}{N} \mathrm{fast\_frf}(x, -1/N) \end{aligned}\right\} \qquad \forall x(n), n = 1..N$$

The Hilbert Fractional Interpolator (HFI) is represented by the following Matlab function:

```
% Hilbert Fractional Interpolator...
% XY = input carriers (from 0..N/2)
% y = time-domain interpolated signal
% ppm = clock mismatch
%
function y = hfi_interp( XY, ppm)
alpha = 1-ppm/1e6;
N = length (XY)*2;
```

y = 2/N*real (fast_frf( [XY(1) /2 ; XY (2:end) ; zeros (N/2,1)], -1/alpha/N));
return;

**Figs 4,5,6 Cyclic Prefix Insertion:**

The cyclic-prefix insertion is a non-linear operation. In a clock-mismatched transmitter this cannot be done simply by prepending the last CP samples as the stretch/shrink effects of the clock-offset will be different at the beginning and at the end of the symbol. Two effects have to be accounted for when the prefix is inserted:

a) the actual N-samples symbol starts CP samples later, which introduces an additional phase offset, and
b) the prefix cannot be copied from the interpolated samples and must be interpolated separately

The 1st effect is addressed with an additional phase-delay of D samples in hk(n):

$$\widetilde{x}_k(n) = \frac{2}{N} X(k) \cdot \exp\left(j\frac{2\pi}{N} kn\right)$$

$$h_{D,k}(n) = \exp(j \cdot \Delta\Phi_k(n+D)) = \exp\left(j\frac{2\pi}{N} k(n+D)\frac{1-\alpha}{\alpha}\right)$$

$$y_D(n) = \sum_{k=0}^{N/2-1} \widetilde{x}_k(n) \cdot h_{D,k}(n) = \frac{2}{N} \sum_{k=0}^{N/2-1} X(k) \cdot \exp\left(j\frac{2\pi}{N} kD\frac{1-\alpha}{\alpha}\right) \cdot \exp\left(j\frac{2\pi}{N} kn\frac{1}{\alpha}\right)$$

(Equation 1)

The 2nd effect is addressed with an additional fractional Fourier call over the same carriers. The idea is to have a zero-phase offset at the sample N-CP as this will become the first interpolated sample. This can be obtained with a negative delay of -(N-CP) samples and keeping only the output samples from N-CP to N-1 as interpolated prefix. In both cases, the main tool is the Delayed Fractional Hilbert Interpolator defined by (Equation 1 and implemented by the following Matlab function:

```
% Delayed Hilbert Fractional Interpolator.
% XY = input carriers (from 0..N/2)
% y = time-domain interpolated signal
% ppm = clock mismatch
% delay = in samples (ex. N-CP+1)
%
function y = delay_hfi__interp( XY, ppm, delay )
alpha = 1-ppm/1e6;
N = length (XY)*2 ;
Xd = [XY (1) /2 ; XY (2:end) ; zeros (N/2,1)];
Xd = Xd .* exp (sqrt (-1)*2*pi/N* (0:N-1)*delay*(1/alpha-1)).';
y = 2/N*real(fast_frf( Xd, -1/alpha/N));
return;
```

The interpolated prefix y_p and the N-samples symbol y_n are then obtained with two fractional Fourier calls over the same carriers with different delays:

```
N=512; CP=32; ppm=251; % xy = carriers 0..N/2
y_p = delay_hfi_interp (xy,ppm, - (N-CP) );
y_p = y_p (N-CP+1:end); % CP samples prefix
y_n = delay_hfi_interp (xy,ppm,CP); % N samples symbol
```

The complete TX HFI Interpolator for the TX path involves combining the interpolation of the symbol and prefix in a single block/function 70, as shown in figure 4. There is some scope for reducing redundancy by sharing common exponential factors as shown in figure 5. The resulting DMT HFI Interpolator for the TX path (from carriers to time-domain) is specified by the following Matlab function. The arguments are the same as before, where CP specifies the length of the prefix in samples (i.e. 32 for ADSL) . yn and yp are the output (fractionally interpolated) symbol and prefix. The two 2N-points fast convolutions have been compacted in a single Matlab function. The pre and post exponential factors (variables A,B,C) are shared between symbol and prefix fast convolvers.

```
% DMT Hilbert Fractional Interpolator...
% XY = input carriers (tones 0..N/2-1)
% ppm = clock mismatch
% CP = cyclix prefix size in samples
% [yn,yp] = interpolated symbol,prefix
%
function [yn, yp] = dmt_hfi__interp ( XY, ppm, CP)
N = length (XY)*2;
alpha = 1-ppm/1e6;
gamma = -1/alpha/N;
Xs = [XY(1)/2 ; XY (2:end)];
Xn = [Xs .* exp (sqrt(-1)*2*pi/N*(0:N/2-1) * (CP) * (1/alpha-1) ) . ' ; zeros (N/2, 1) ] ;
Xp = [Xs .* exp (sqrt (-1) *2*pi/N* (0 :N/2-1) * (CP-N)*(1/alpha-1)).';zeros (N/2,1)];
A = exp (-sqrt (-1) *pi* (0 :N-1) . ^2*gamma) . ' ;
B = exp (sqrt(-1)*pi*(0:N) . ^2*gamma) . ' ;
B = fft ( [ B ; B (end-1:-1:2) ] ) ;
C = A (1:N);
an = [Xn .* A ; zeros (N, 1) ] ;
bn = ifft( fft (an) .* B );
yn = 2/N * real ( bn (1:N) .* C );
ap = [Xp .* A ; zeros (N, 1) ] ;
bp = ifft( fft (ap) .* B );
yp = 2/N * real ( bp (1:N) .* C );
yp = yp (N-CP+1:N);
return;
```

This specification is already suitable for a fast hardware implementation of the HFI that employs standard FFT blocks and multipliers. Implementation of the HFI Interpolator in the TX path can be done with two FRFT (Fractional Fourier Transform) calls, from the carrier domain, directly to the fractional time-domain grid, without an additional TDI in the TX path. This is represented in figure 4 which shows the HFI part 70 comprises a first FR-FT block 80 for processing the symbol, and a second block 90, for processing the prefix. Both have as inputs the frequency domain carriers and the clock offset estimate. The outputs of the blocks are combined by block 85. Prefix insertion involves pre-pending some samples at the beginning of the DMT frame. The result is a DMT frame longer in time but the values are the same as before to produce the time domain output having the prefix.

Each FR-FT block in figure 4 can be implemented following the Matlab function fast_frf () as shown in figure 5 which is an embodiment of the present invention. An M-point Fractional Fourier is obtained using several 2M-points traditional Fourier transforms. In this figure, the signal path is fed through a series of blocks including a first multiplier, a zero pad, an FFT 2m, a second multiplier, an IFFT 2M, a $1^{st}$ half element, and a third multiplier. The first and third multipliers have as their other inputs a value $exp(-j\, n^2)$ for n=0 :M-1, derived from the clock offset signal represented by . However, this representation of alpha is relevant to this application and may represent other functions in other applications. The second multiplier has as its other input, the value $exp(j\, n^2)$ for n=0:M, after that value is subjected to a phase copy and an FFT 2M operation.

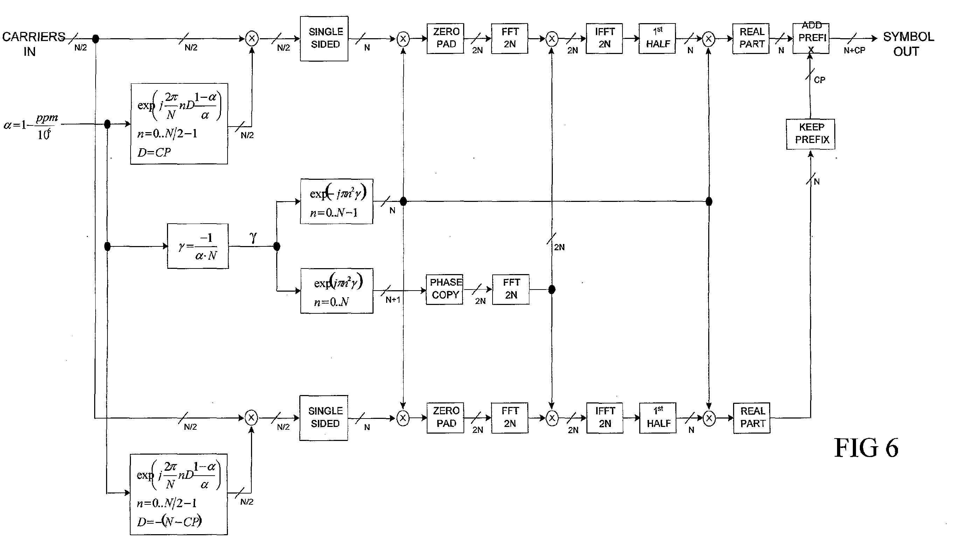

Following the previous derivations, the complete HFI block 70 specified by function dmt_hfi_interp () can be implemented as shown in the block diagram of fig 6. As can be seen this diagram represents essentially an expansion or implementation of figure 4 using the parts shown in figure 5. An additional step not shown in figure 5 is a multiplication of the carriers at the input by a factor exp {j[2 /N]nD [1- ]/ } for n=0.N/2-1, D=CP or D=-(N-CP)respectively to achieve the desired delays. This is followed by a "single sided" operation. Also, as the other inputs to the three multipliers are common to both the FR-FT blocks, the derivation of these inputs is shared rather than duplicated, to minimize computational load.

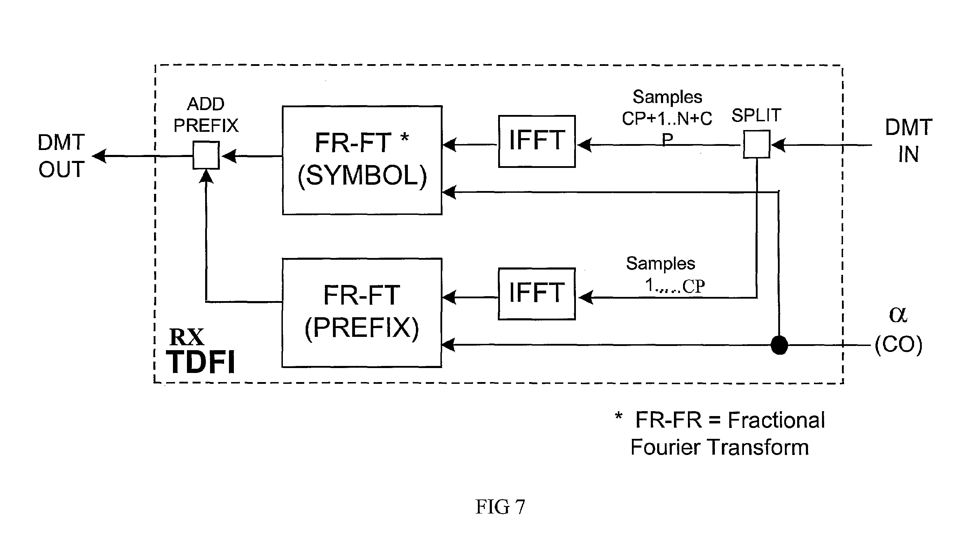

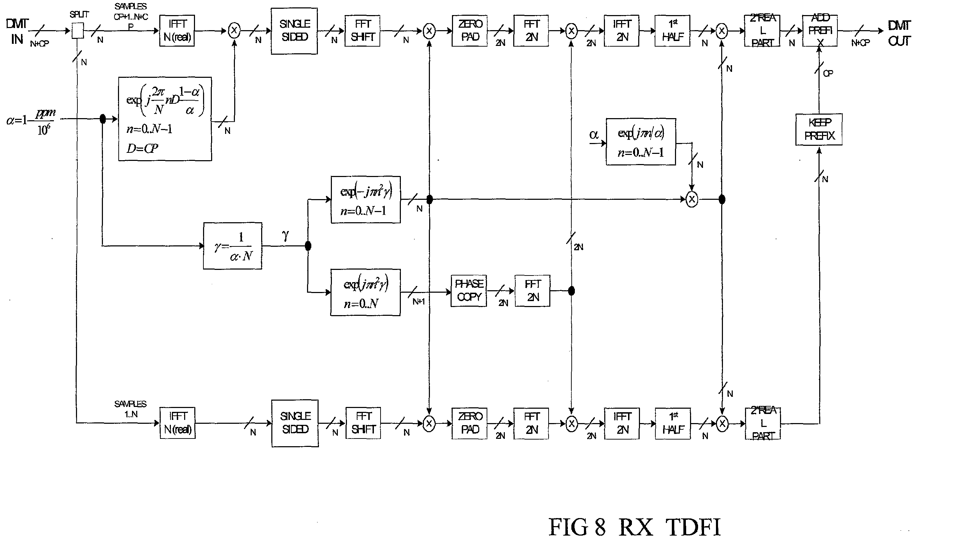

## Figs 7, 8, Fractional Interpolation in the RX path.

Given the presence in the RX path of a time-equalizer, the approach used for the TX path cannot be applied directly. Thus, the received symbol, sampled with the local clock, has to be interpolated and output in the same domain, to enable it to be passed through the time-equalizer. A well known technique to do time interpolation with a normal DFT exists and can be extended for a fractional delay by means of the Fractional Fourier Transform. A notable advantage over the classical DFT approach is that the complexity of the resulting interpolator does not depend on the fractional delay.

The same notation as for the function delay_hfi_interp() is used. The input argument 'x' now represents the received symbol in the time-domain. The time domain fractional interpolator is specified as follows.

```
% Time-to-Time Fractional Interpolator...
% x = input symbol (N samples)
% ppm = clock mismatch
% delay = ...in samples
% y = interpolated symbol
%
function y = delay_tdfi_interp( x, ppm, delay )
N = length (x) ;
alpha = 1-ppm/1e6;
Y = ifft(x) .* exp (-sqrt (-1) *2*pi/N* (0 :N-1) *delay* (1-alpha) /alpha).';
Z = fftshift( [Y (1) /2 ; Y (2:N/2); Y (N/2+1) /2 ; zeros (N/2-1,1)] );
y = 2*real(fast_frf( ( Z , 1/alpha/N ) . * exp (sqrt (-1)*pi* (0:N-1) /alpha).');
return;
```

The interpolated prefix 'y_p' and the N-samples symbol 'y_n' are then obtained with two fractional Fourier calls over different parts of the received (N+CP samples long) symbol 'xx', with different delays:

```
N=512; CP=32; ppm=251; % xx is N+CP samples = received DMT
y_n = delay_tdfi_interp( xx(CP+1:N+CP), ppm, CP );
y_p = delay_tdfi_interp ( xx(1:N), ppm, 0 ) ;
Y_p = y_p(1:CP);
```

The complete Fractional Interpolator for the RX path involves combining the interpolation of the symbol and prefix in a single block/function where the redundancies are minimized by sharing common exponential factors. A high level view is shown in figure 7 and more detail of a possible implementation is shown in figure 8. Again in figure 8, as the other inputs to the three multipliers are common to both the FR-FT blocks, the derivation of these inputs is shared rather than duplicated, to minimize computational load. First the matlab representation is set out.

```
% DMT Time-to-Time Fractional Interpolator...
% xx = input symbol (N+CP samples)
% ppm = clock mismatch
% CP = cyclix prefix size in samples
% [yn,yp] = interpolated symbol,prefix
%
function [yn, yp] = dmt_tdfi_interp ( xx, ppm, CP )
N = length(xx) - CP;
alpha = 1-ppm/1e6;
gamma = 1/alpha/N;
A = exp (-sqrt (-1) *pi* (0 :N-1) . ^2*gamma) . ' ;
B = exp (sqrt (-1) *pi* (0 :N) . ^2*gamma) . ' ;
B = fft ( [ B ; B (end-1:-1:2) ] );
C = A (1:N) .* exp (sqrt (-1)*pi*(0:N-1) /alpha).';
Yn = ifft (xx (CP+1:N+CP)) .* exp (-sqrt (-1)*2*pi/N*(0:N-1)*CP*(1-alpha) /alpha).';
Zn = fftshift ( [Yn (1) /2 ; Yn(2:N/2) ; Yn (N/2+1) /2 ; zeros (N/2-1,1)] );
Yp = ifft (xx(1:N));
Zp = fftshift( [Yp (1) /2 ; Yp(2:N/2); Yp (N/2+1) /2 ; zeros (N/2-1,1)] );
an = [Zn .* A ; zeros (N, 1) ] ;
bn = ifft( fft (an) .* B );
yn = 2 * real ( bn (1:N) .* C );
ap = [Zp .* A ; zeros(N,1)] ;
bp = ifft( fft (ap) * B );
yp = 2 * real ( bp(1:CP) .* C (1:CP) );
return;
```

This specification is ready for a fast hardware implementation of the TDFI that employs standard FFT blocks and multipliers. The Fractional Interpolator in the RX path of the received symbol has input and output in the time-domain, and is achieved by two FRFT (Fractional Fourier Transform) calls as shown in figure 7. This shows the input signal being split, with samples 1....CP being fed to an IFFT which feeds the FR-FT (PREFIX) part. Samples CP+1.... N+CP are fed to an IFFT which feeds FR-FT (SYMBOL). As in figure 4, the clock offset is fed to both FR-FT blocks, and the outputs of the blocks are concatenated. The FR-FT block is again the one shown in figure 4. A complete block diagram for the RX interpolator shown in figure 8, follows the Matlab function dmt_tdfi_interp() set out above. It is similar to that of figure 6, and so need not be described further. Notably, there is no delay operator at the input to the FR-FT (PREFIX) part, the bottom row of the figure because the prefix starts at sample 0, i.e. without any delay in position. The prefix is pre-pended to the frame.

Alternative implementations for the RX side clock offset compensation can be envisaged if the TEQ need not be implemented, or if it can be implemented elsewhere, or implemented in the frequency domain, so that the clock offset outputs can be in the frequency domain. For example, in the latter case a structure is created very similar to the TX HFI but reversed in the order of the FFT/Chirp-Z transforms.

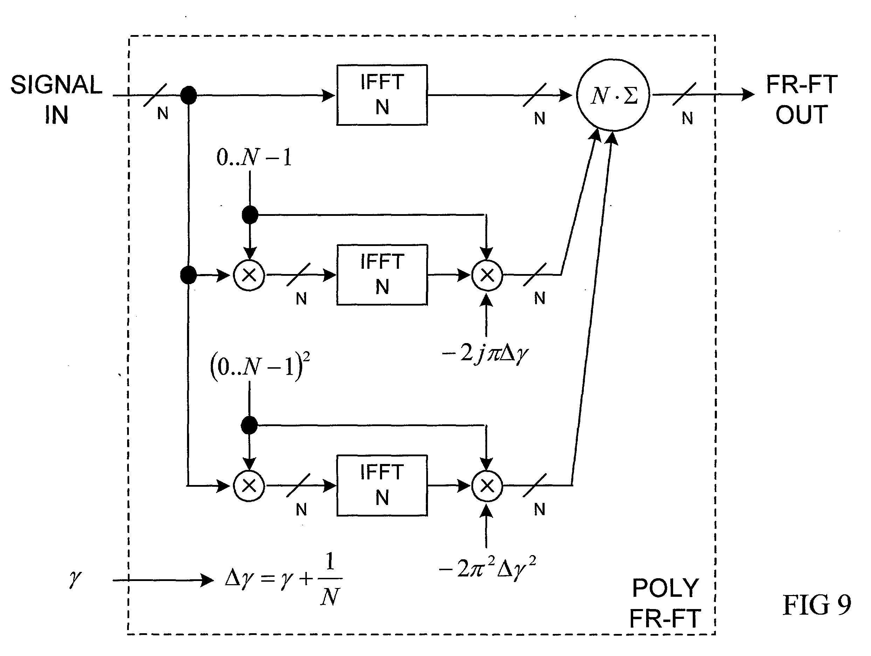

**Fig 9, Approximations of the Fractional Fourier Transform**

The structures presented so far are exact, in the sense that they give the performance of an ideal trigonometric interpolator over N samples. To find solutions which are computationally cheaper and still acceptable in terms of performances, the fractional Fourier transform block has to be approximated in some way.

One way is by series expansion (more suitable for TX path than RX path), and an example is shown in figure 9, as will now be explained. The argument in each call to the fractional Fourier transform in the TX path is:

$$\gamma = \frac{-1}{\alpha N} = \frac{1}{\left(1 - ppm \cdot 10^{-6}\right)N} \approx \frac{-1}{N}$$

$$\Delta\gamma = \gamma - \left(\frac{-1}{N}\right) = \frac{ppm}{\left(ppm - 10^6\right)N}$$

$\Delta\gamma$ is very small in the low ppm range of interest. This suggests a Taylor series decomposition of the Fractional Fourier kernel around the point -1/N as follows:

$$\exp(-j2\pi nk\gamma) \approx \exp\left(j\frac{2\pi}{N}nk\right) - 2j\pi nk\left(\gamma + \frac{1}{N}\right)\exp\left(j\frac{2\pi}{N}nk\right) +$$

$$-2\pi^2 n^2 k^2\left(\gamma + \frac{1}{N}\right)^2 \exp\left(j\frac{2\pi}{N}nk\right) + \frac{4}{3}j\pi^3 n^3 k^3\left(\gamma + \frac{1}{N}\right)^3 \exp\left(j\frac{2\pi}{N}nk\right) + ...$$

Thus, the fractional Fourier has been turned into a sum of windowed Fourier transforms applied to windowed versions of the input vector, where the windows are constant, linear, parabolic etc.

$$\left.\begin{array}{l}G_k\left(s(n),\gamma\right) = \displaystyle\sum_{n=0}^{N-1} s(k) \cdot \exp\left(-j2\pi nk\gamma\right) \\ F_k^{-1}\left(s(n)\right) = \dfrac{1}{N}\displaystyle\sum_{n=0}^{N-1} s(k) \cdot \exp\left(j\dfrac{2\pi}{N}nk\right)\end{array}\right\} \qquad n,k = 0..N-1$$

$$G_k\left(s(n),\gamma\right)\frac{1}{N} \approx F_k^{-1}\left(s(n)\right) - 2j\pi k F_k^{-1}\left(n \cdot s(n)\right)\Delta\gamma - 2\pi^2 k^2 F_k^{-1}\left(n^2 \cdot s(n)\right)\Delta\gamma^2 + ...$$

The approximation is good for low tones but degrades rapidly with the tone index. Also, the method is limited by the high dynamic range required to window the input vector. Thus, it is suitable only when the input vector has only a small initial subset which is non-zero. This is the case for the Upstream TX path when oversampling is employed in the TX-IFFT. There, only few carriers are active with respect to the number of points N of the IFFT (i.e. carriers 7-31 with N=512).

The block diagram (showing the 1st, 2nd and the 3rd terms of the series) derived from the equation is shown in figure 9. For each term there is an IFFT N part and a pre-multiplier and a post multiplier. The pre-multiplier produces a product of the input signal and a factor and feeds the product to the IFFT N part. The output of the IFFT N part is fed to the post-multiplier whose output is multiplied by the same factor and another factor derived from the clock offset, to generate the term. All the terms are then summed to give the final output. The factors are given in the equation above. This 'POLY FR-FT' block can be plugged directly in Fig. 4 as a replacement of the 'FR-FT' block. The appropriate delays for the symbol and prefix have to be included as in Fig. 6. The complexity in real multiplications per symbol can be about half the complexity of an HFI TX interpolator.

**Figure 10, rate adapter**

Figure 10 shows an embodiment for general purpose rate adaptation. A rate adapter 390 has an input part 410 and a fractional interpolator 420. An input signal is fed to the input part 410 which feeds block of data to the fractional interpolator 420. The interpolator operates on the blocks according to a rate control signal, to produce a rate adapted output. The input part 410 can be implemented as a storage buffer. The fractional interpolator can be implemented as described above for example. Generally, the two rates are almost the same, the target ppm range is tenths/hundreds of ppm.

Summary

As has been described above, a fractional fast Fourier transform arrangement has been described. The arrangement can be applied to receivers or transmitters of multicarrier modems, or any application which needs rate adaption or synchronization.

Any of the functions shown can be implemented using standard software languages or procedures, for execution on standard hardware such as general purpose microprocessors, DSPs, or application specific integrated circuits, for example. The modem, receiver or transmitter structures can be efficiently implemented with DSP cores for example for single chip products. The software contains code which may execute on any suitable computing device or processing engine having memory such as a microprocessor, e.g. Pentium IV supplied by Intel Corp. USA or similar, or a programmable gate array such as a Field Programmable Gate Array, Programmable Array Logic, Programmable Logic Array or similar. The software may also be stored on a suitable data carrier, e.g. an optical disk such as a CD-ROM, a DVD-ROM; magnetic tape; a hard disk; a memory of a network element in a telecommunications network or in a personal computer or a work station such as a UNIX workstation.

Other variations will be apparent to those skilled in the art, having corresponding advantages to those set out above, within the scope of the claims. For instance reference has been made to discrete Fast Fourier Transforms and their inverses as well as a fractional variation of these, but similar results may be obtained with other wave or wavelet based transforms such as the Discrete Wavelet Transform and its inverse. For the latter a fractional variant is generated.

**Claims**

1. A Fractional Fourier Transform arrangement comprising at least one 2N-points fast Fourier transform block.

2. The arrangement of claim 1, further comprising a 2N-points inverse fast Fourier transform block.

3. The arrangement of claim 1 or 2, further comprising a second 2N-points fast Fourier transform block.

4. The arrangement claim 3, further comprising a signal path fed through a first multiplier, the at least one 2N-points fast Fourier transform block, a second multiplier, the 2N-points inverse fast Fourier transform block, a $1^{st}$ half element, and a third multiplier.

5. The arrangement of claim 4, wherein the first and third multipliers have other inputs connected to an exponential block for calculating $\exp(-j\, n^2)$ for n=0 :M-1, derived from a signal having a value.

6. The arrangement of claim 4 or 5 wherein the second multiplier has another input connected to a further block for calculating a value $\exp(j\, n^2)$ for n=0:M, after that value is subjected to a phase copy and an FFT 2M operation.

7. A transmitter having an arrangement according to any preceding claim.

8. A receiver having an arrangement according to any preceding claim.

**9.** A modem having the transmitter of claim 7 and the receiver of claim 8.

**10.** An integrated circuit incorporating the arrangement of any of the claims 1 to 6 or the modem of claim 9.

**11.** Software comprising executable code for implementing the arrangement of any of claims 1 to 6.

EP 1 434 142 A1

Customer Premises' Equipment 200

TRANSM. PATH E.G. SUBSCRIBER LINE

MODEM 225

TRANSMITTER SIDE

CO 220

DAC 5

XO 2

ADC 6

TX FILTER 4

RX FILTER 7

TX TDFI AND IFFT AND CP 3

CLOCK OFFSET ESTIMATOR 1

RX TDFI 9

MAPPER 230

TEQ 250

FFT AND CP 8

DE-MAP 240

RECEIVER SIDE

MUX DEMUX OR SWITCH OR OTHER CO FUNCTIONS 245

REST OF PSTN AND OTHER NETWORKS 400

FIG 1

15

TX  TDFI  AND IFFT AND CP    3

FREQUENCY
DOMAIN
CARRIERS

IFFT
20

CZT
30

IFFT
40

CP
50

TIME
DOMAIN
SYMBOLS

CCI 60

**FIG 2**

ESTIMATED
CLOCK
OFFSET

TX TDFI AND IFFT AND CP    3

HFI  70

FREQUENCY
DOMAIN
CARRIERS

FR-FT
(SYMBOL)
80

FR-FT
(PREFIX)
90

+

TIME
DOMAIN
SYMBOLS

**FIG 4**

ESTIMATED
CLOCK
OFFSET

SINGLE
CARRIER $\xrightarrow{\text{IFFT}}$ time-domain
X(k)

causal
signal $x_k(n)$ $\xrightarrow{\text{HT}}$ time-domain
analytic
signal $\tilde{x}_k(n)$ $\xrightarrow[\substack{h_k(n)}]{\text{phase} \\ \text{delay}}$ time-domain
interpolated
analytic
signal $\tilde{y}_k(n)$ $\xrightarrow{\text{Real}}$ $\Sigma$ $\rightarrow$ time-domain
causal
interpolated
signal y(n)

Other
Carriers

## FIG 3

INPUT
STREAM

RATE ADAPTER   390

RATE
ADAPTED
OUTPUT

BLOCKS
410 $\rightarrow$ FRACTIONAL
INTERPOLATOR
420 $\rightarrow$

RATE CONTROL SIGNAL
390

## FIG 10

EP 1 434 142 A1

FIG 5

FIG 6

FIG 7

EP 1 434 142 A1

EP 1 434 142 A1

DMT IN  /N+CP  SPLIT

SAMPLES CP+1..N+CP  /N

IFFT N(real) → ⊗ → /N → SINGLE SIDED → /N → FFT SHIFT → /N → ⊗ → ZERO PAD → /2N → FFT 2N → ⊗ → /2N → IFFT 2N → 1st HALF → /N → ⊗ → 2*REAL PART → /N → ADD PREFIX → /N+CP → DMT OUT

$\alpha = 1 - \dfrac{ppm}{10^6}$

$\exp\left(j\dfrac{2\pi}{N}nD\dfrac{1-\alpha}{\alpha}\right)$
$n = 0..N-1$
$D = CP$

$\gamma = \dfrac{1}{\alpha \cdot N}$  $\gamma$

$\exp(-j\pi n^2\gamma)$
$n = 0..N-1$

$\exp(j\pi n^2\gamma)$
$n = 0..N$  /N+1 → PHASE COPY → /2N → FFT 2N

$\alpha$  $\exp(j\pi n/\alpha)$
$n = 0..N-1$  /N

KEEP PREFIX  /N  /CP

SAMPLES 1..N  IFFT N(real) → /N → SINGLE SIDED → /N → FFT SHIFT → /N → ⊗ → ZERO PAD → /2N → FFT 2N → ⊗ → /2N → IFFT 2N → 1st HALF → /N → ⊗ → 2*REAL PART

FIG 8  RX  TDFI

FIG 9

EP 1 434 142 A1

**European Patent**

**Office**

## PARTIAL EUROPEAN SEARCH REPORT

**Application Number**

which under Rule 45 of the European Patent Convention EP 02 44 7274
shall be considered, for the purposes of subsequent
proceedings, as the European search report

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | D.H. BAILEY ET AL: "The Fractional Fourier Transform and Applications" HTTP://SCIENCE.NAS.NASA.GOV, [Online] 22 October 1990 (1990-10-22), pages 1-19, XP002246429 Retrieved from the Internet: <URL:http://science.nas.nasa.gov/Pubs/Tech Reports/RNReports/dbailey/RNR-90-004/RNR-90-004.o.html> [retrieved on 2003-07-03] * page 12, line 13 - page 15, line 21 * * page 2, line 1 - page 7, line 30 * --- -/-- | 1-4,6,11 | G06F17/14 |

**TECHNICAL FIELDS SEARCHED (Int.Cl.7)**

G06F

### INCOMPLETE SEARCH

The Search Division considers that the present application, or one or more of its claims, does/do not comply with the EPC to such an extent that a meaningful search into the state of the art cannot be carried out, or can only be carried out partially, for these claims.

Claims searched completely :

Claims searched incompletely :

Claims not searched :

Reason for the limitation of the search:

see sheet C

| Place of search | Date of completion of the search | Examiner |
|---|---|---|
| MUNICH | 3 July 2003 | Barba, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C07)

| | | |
|---|---|---|
| **European Patent Office** | **INCOMPLETE SEARCH SHEET C** | Application Number<br>EP 02 44 7274 |

Claim(s) searched completely:
    1-4

Claim(s) searched incompletely:
    6, 11

Claim(s) not searched:
    5, 7-10

Reason for the limitation of the search:

With regard to dependent Claim 5 the following comments are submitted.
Claim 5 has not been searched because it is unclear (Article 84 EPC) to
such an extent that no meaningful search could have been carried out, the
reasons therefor being the following.
In the wording of claim 5 it is made reference to a signal wherein,
according to the present wording of claim 5, a specific value should have
been assigned. However, in the text of claim 5 this assigned value is not
specified (this part of claim 5 has been left blank). Moreover, in the
present case also the description does not provide any useful indication;
in fact, from the originally filed description, it appears that the
subject matter of claim 5 refers to an embodiment of the system of the
application as described at page 19 of the filed description; however,
also the description fails to define said value (the relevant part of the
description has been left blank).
Thus, the text of the claim is not considered complete because the
definition of the signal from which the other input connected to the
exponential block is derived is missing; moreover, this same definition
is also missing in the text of the description, making therefore
impossible to determine with certainty and unambiguously the scope of the
subject matter intended to be claimed.

With regard to independent claims 7 to 10 the following comments are
submitted. The text of claims 7 to 10 makes vague and unclear reference
to the possible implementation of the system defined in previous claims 1
to 6 into a transmitter, a receiver, a modem and an integrated circuit
respectively.
Thus, present claims 7 to 10 relate to an extremely large number of
possible apparatus. In fact, the claims contain so many options,
variables, possible permutations and provisos that a lack of clarity (and
conciseness) within the meaning of Article 84 EPC arises to such an
extent as to render a meaningful search of the claims impossible.
Moreover, for the same reasons above mentioned the subject matter of
claims 7 to 10 lacks support within the meaning of Article 84 EPC and
disclosure within the meaning of Article 83 EPC.
Consequently, no search has been carried out for these claims.

With regard to dependent claim 6 and independent claim 11 the following
comments are submitted.
Taking into account the above mentioned comments concerning dependent
claim 5, and the dependency relationship of this claims from dependent
claim 5, the scope of the search for these claims has been restricted to
their subject matter as dependent only on claim 4 for what concerns claim
6, and claims 1 to 4 and 6 (when only depending on claim 4) for what

concerns claim 11.

**European Patent Office**

## PARTIAL EUROPEAN SEARCH REPORT

Application Number

EP 02 44 7274

| | DOCUMENTS CONSIDERED TO BE RELEVANT | | CLASSIFICATION OF THE APPLICATION (Int.Cl.7) |
|---|---|---|---|
| Category | Citation of document with indication, where appropriate, of relevant passages | Relevant to claim | |
| A | CARIOLARO G ET AL: "Multiplicity of fractional Fourier transforms and their relationships" IEEE TRANSACTIONS ON SIGNAL PROCESSING, JAN. 2000, IEEE, USA, vol. 48, no. 1, pages 227-241, XP002246430 ISSN: 1053-587X * page 236, left-hand column, line 25 - right-hand column, line 28 * * page 232, right-hand column, line 1 - page 236, left-hand column, line 18 * * page 229, left-hand column, line 32 - page 230, right-hand column, line 30 * --- | 1-4,6,11 | |
| A | AKAY O ET AL: "Broadband interference excision in spread spectrum communication systems via fractional Fourier transform" SIGNALS, SYSTEMS & COMPUTERS, 1998. CONFERENCE RECORD OF THE THIRTY-SECOND ASILOMAR CONFERENCE ON PACIFIC GROVE, CA, USA 1-4 NOV. 1998, PISCATAWAY, NJ, USA,IEEE, US, 1 November 1998 (1998-11-01), pages 832-837, XP010324272 ISBN: 0-7803-5148-7 * page 834, right-hand column, line 1 - page 835, right-hand column, line 20 * * page 832, right-hand column, line 30 - page 833, left-hand column, line 18 * --- -/-- | 1-4,6,11 | TECHNICAL FIELDS SEARCHED (Int.Cl.7) |

EPO FORM 1503 03.82 (P04C10)

**European Patent Office**

**PARTIAL EUROPEAN SEARCH REPORT**

Application Number

EP 02 44 7274

| | DOCUMENTS CONSIDERED TO BE RELEVANT | | CLASSIFICATION OF THE APPLICATION (Int.Cl.7) |
|---|---|---|---|
| Category | Citation of document with indication, where appropriate, of relevant passages | Relevant to claim | |
| A | OZAKTAS H M ET AL: "Convolution, filtering, and multiplexing in fractional Fourier domains and their relation to chirp and wavelet transforms" JOURNAL OF THE OPTICAL SOCIETY OF AMERICA A (OPTICS AND IMAGE SCIENCE), FEB. 1994, USA, vol. 11, no. 2, pages 547-559, XP002246431 ISSN: 0740-3232 * page 553, right-hand column, line 1 - page 555, left-hand column, line 43 * * page 550, left-hand column, line 26 - page 551, right-hand column, line 17 * ----- | 1-4,6,11 | |
| | | | TECHNICAL FIELDS SEARCHED (Int.Cl.7) |